# EUROPÄISCHE PATENTSCHRIFT

(11) **EP 0 581 919 B1**
(45) Veröffentlichungstag und Bekanntmachung des Hinweises auf die Patenterteilung: **22.05.1996**
(21) Anmeldenummer: 93902082.2
(22) Anmeldetag: 05.02.1993
(51) Int. Cl.: H05K 5/00, H05K 7/20

(54) **GEHÄUSE FÜR STEUERGERÄTE**
HOUSING FOR CONTROL DEVICES
BOITIER POUR APPAREILS DE COMMANDE

(30) Priorität: 21.02.1992 DE 4205388; 21.07.1992 DE 4224008; 19.12.1992 DE 4243180
(43) Veröffentlichungstag der Anmeldung: 09.02.1994
(73) Patentinhaber: ROBERT BOSCH GMBH, 70442 Stuttgart (DE)
(72) Erfinder: HUSSMANN, Dieter, D-7141 Steinheim (DE); JESSBERGER, Thomas, D-7147 Eberdingen (DE); KARR, Dieter, D-7533 Tiefenbronn (DE); SCHUPP, Karl, D-7530 Pforzheim (DE); JARES, Peter, D-7032 Sindelfingen (DE); NEUHAUS, Dieter, D-7157 Sulzbach (DE); HARSCH, Markus, D-7144 Asperg (DE); WEBER, Bernd, D-7101 Abstatt (DE)
(86) Internationale Anmeldenummer: DE9300095
(87) Internationale Veröffentlichungsnummer: WO9317535

(56) Entgegenhaltungen:
- DE-A- 3 128 856
- DE-C- 4 023 319
- GB-A- 2 239 739

## Beschreibung

### Stand der Technik

Die Erfindung geht von einem wie z.B. aus DE-A- 40 23 319 bekannten Gehäuse für Steuergeräte nach der Gattung des Patentanspruchs 1 aus. Bei solchen Steuergeräten besteht die Forderung, daß sie einerseits stabil sind und die elektrischen Bauelemente sicher lagern und von schädlichen Beeinflussungen schützen sollen, zum anderen soll eine elektronische Schaltung, die in solchen Gehäusen untergebracht ist, vor elektrischen Störeinstrahlungen von außen auf die Schaltung geschützt sein. Genauso gut soll aber auch eine in der elektrischen Schaltung entstehende Störstrahlung nicht nach außen gelangen dürfen. Weiterhin sollen auch störeinstrahlempfindliche Bauelemente vor der Abstrahlung von störabstrahlenden Bauelementen gesichert sein. Schließlich soll die in der elektrischen Schaltung in dem Bauelement entstehende Wärme sicher abtransportiert werden, so daß es zu keiner Schädigung der Bauelemente oder zu einer Funktionsbeeinträchtigung kommt.

### Vorteile der Erfindung

Das erfindungsgemäße Gehäuse für Steuergeräte gemäß den kennzeichnenden Merkmalen des Patentanspruchs 1 hat den Vorteil, daß in einfacher und sicherer Weise die entstehende Wärme der Leistungsbauelemente abgeführt wird und die Gehäuseteile abstrahldicht und einstrahldicht elektrisch und thermisch miteinander verbunden sind.

Insbesondere bei einer beidseitigen Kaschierung gemäß Patentanspruch 2 ergibt sich eine sehr kostengünstige und auch leicht montierbare elektrische und wärmeleitende Verbindung zwischen den Gehäuseteilen. Durch die Unteransprüche 3 bis 8 ergeben sich günstige Ausgestaltungen für die elektrisch leitende und wärmeleitende Kaschierung.

Durch die Ausgestaltung nach Anspruch 9 wird in vorteilhafter Weise eine wärmeleitende Verbindung zwischen den Wärmequellen der elektrischen Schaltung hergestellt.

In weiterer verbesserter Ausgestaltung ergibt sich gemäß den Patentansprüchen 10 und 11 durch die Stege einerseits eine mechanische Stabilisierung und eine Verbesserung der Schwingungsstabilität der Gehäuseteile, andererseits eine intensivere Einspannung der Leiterplatte und Vergrößerung der wärmeleitenden und elektrisch leitenden Verbindung zwischen den Gehäuseteilen. Bei der Unterbringung der Leistungsbauelemente gemäß Patentanspruch 12 und 13 ergibt sich hier eine thermische Trennung von stark Wärme entwickelnden Leistungsbauelementen von Bauelementen anderer Art und eine verbesserte Wärmeabfuhr auch über Wärmestrahlung an die die Leistungsbauelemente umschließenden Wandteile. Gleichzeitig kann bei der parzellenartigen Unterteilung der Leiterplatte die Konvektion der von den Leistungsbauelementen erzeugten Wärme, örtlich begrenzt werden.

In besonders vorteilhafter Weise sind gemäß der Ausführung nach Anspruch 14 weitere Versteifungen des Gehäuses vorgesehen, die zudem die Funktion elektrischer Störabschirmung innerhalb des Gehäuses wahrnehmen. Nach Anspruch 15 erfolgt hier auch eine thermisch und elektrisch leitende Verbindung zwischen den Stutzen, so daß diese im Innern ein störabgeschirmtes Gehäuseteil bilden. In besonders vorteilhafter Weise werden die von Störeinstrahlung zu schützenden oder gegen Störabstrahlung zu schützenden Bauelemente innerhalb des vom Stutzen umschlossenen Bereichs angeordnet.

### Zeichnung

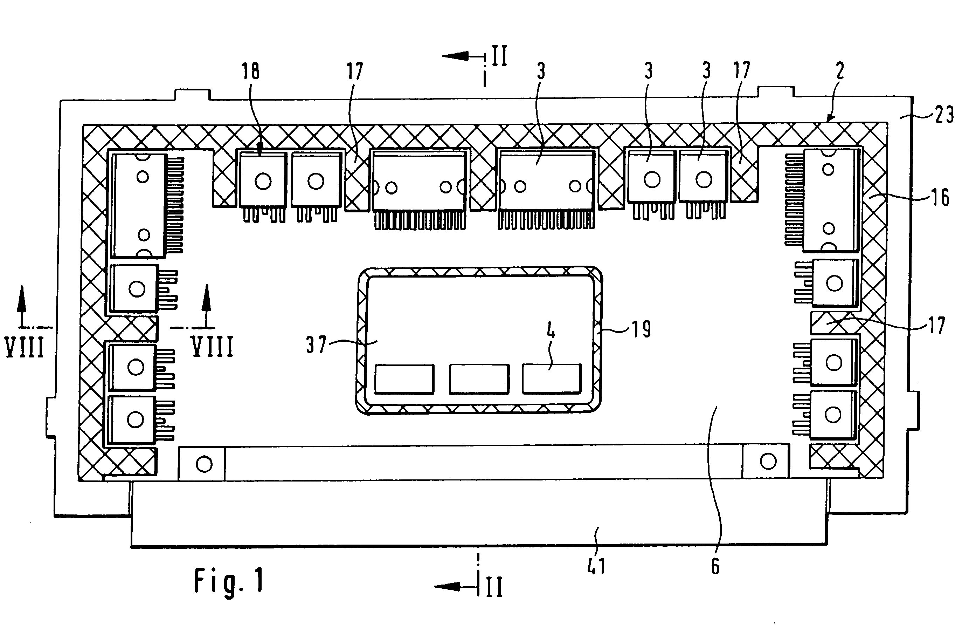

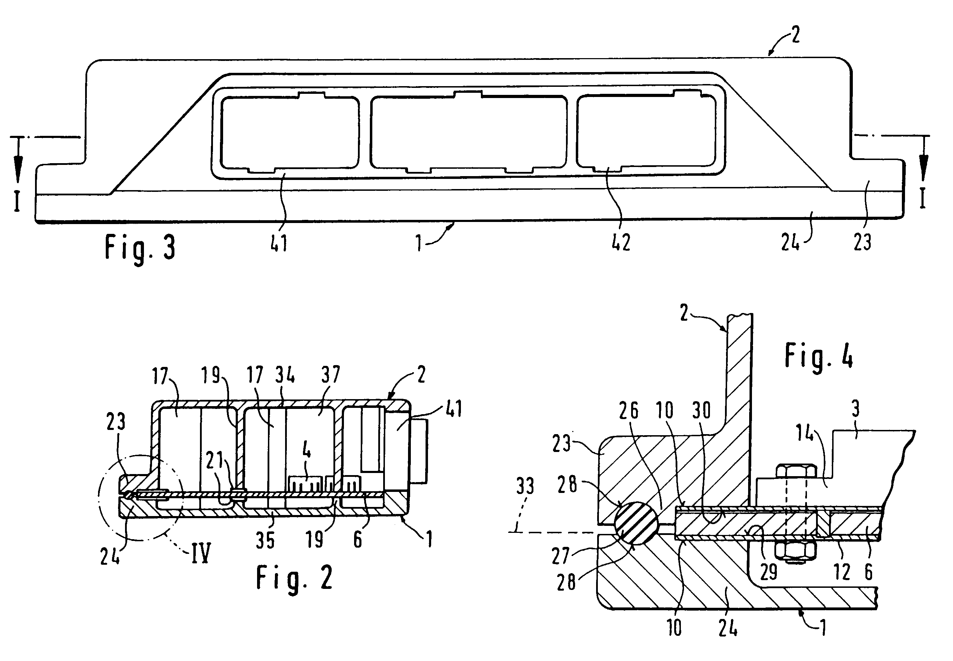

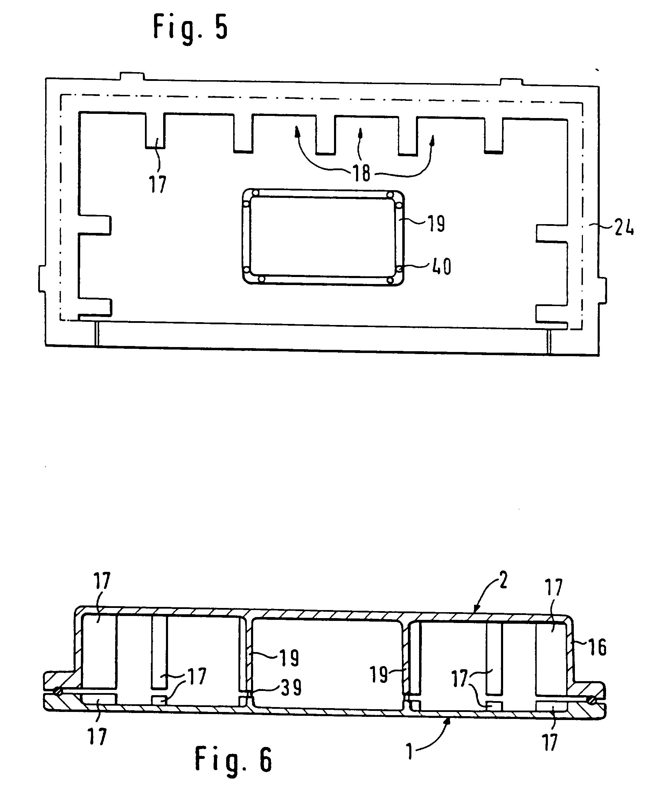

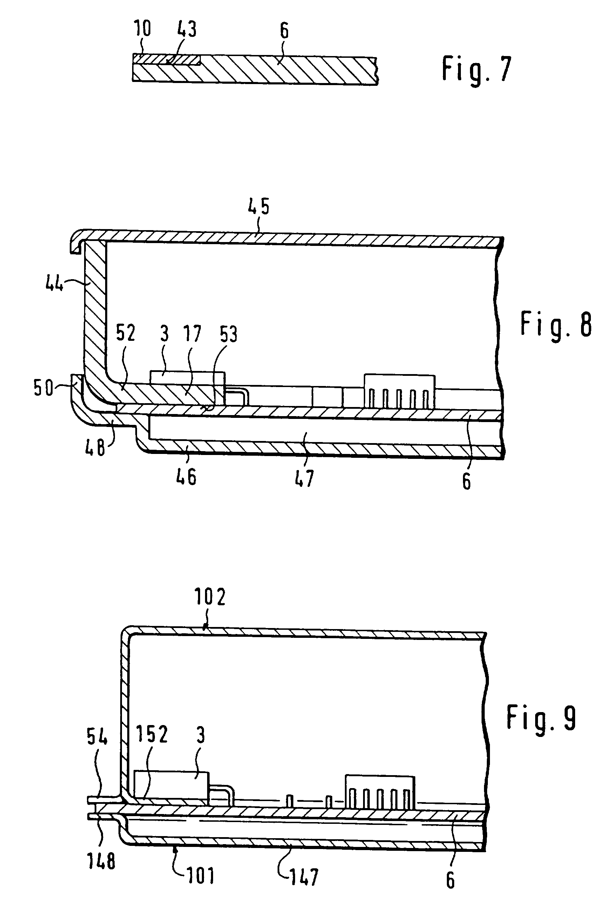

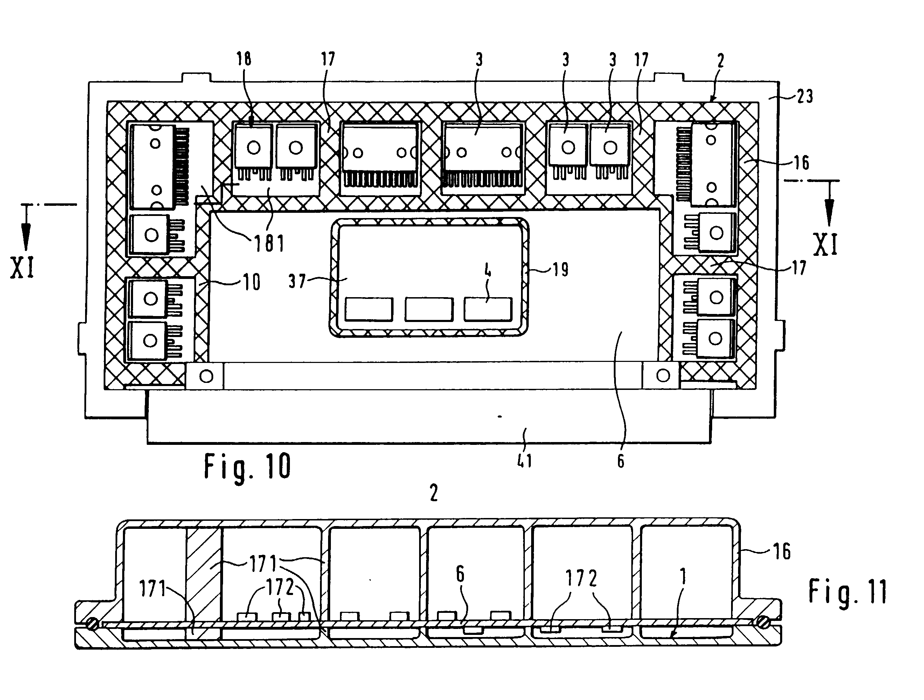

Mehrere Ausführungsbeispiele der Erfindung sind in der Zeichnung dargestellt und werden in der nachfolgenden Beschreibung näher erläutert. Es zeigen Figur 1 einen Schnitt parallel zur Trennebene der Gehäuseteile eines ersten Ausführungsbeispiels eines Gehäuses für Steuergeräte, Figur 2 einen Schnitt gemäß Linie II-II in Figur 1 durch das Gehäuse für Steuergeräte, Figur 3 eine Seitenansicht des erfindungsgemäßen Steuergehäuses von Figur 1 auf der Seite des elektrischen Anschlusses, Figur 4 einen vergrößerten Ausschnitt aus IV von Figur 2, Figur 5 eine Draufsicht auf die Stirnseite einer Gehäusehälfte in der Trennebene zwischen den Gehäusehälften, Figur 6 einen Schnitt durch die zusammengesetzten Gehäusehälften des erfindungsgemäßen Gehäuses ohne Leiterplatte, Figur 7 ein zweites Ausführungsbeispiel der Erfindung mit in die Leiterplatte eingelassener Kaschierung, Figur 8 ein drittes Ausführungsbeispiel der Erfindung mit einem dreiteiligen Gehäuse, dessen einer Gehäuseteil die Leiterplatte umfangsseitig überragt und Figur 9 eine Variante der Gehäuseform mit einer zum Teil nach innen und zum Teil nach außen umgebogenen und so einen Flansch bildenden Gehäusewand. Figur 10 zeigt einen Schnitt parallel zur Trennebene der Gehäuseteile eines weiteren Ausführungsbeispiels eines Gehäuses für Steuergeräte, Figur 11 einen Schnitt gemäß Linie XI-XI in Figur 10 durch das Gehäuse.

### Beschreibung des Ausführungsbeispiels

Figur 1 zeigt einen Schnitt durch den Deckel 2 eines Gehäuses für Steuergeräte. Dabei ist mit der gerauteten Fläche die Schnittfläche durch die Wand des Deckels dargestellt. Außen umlaufend um die Schnittfläche ist ein Flansch 23 erkennbar, der in der darunter stehenden Figur 3 in der Seitenansicht gezeigt ist. Von der geschnittenen Umfangswand 16 ragen ins Gehäuseinnere Stege 17, die Nischen 18 zusammen mit der Umfangswand 16 bilden, innerhalb denen elektrische Leistungsbauelemente 3 angeordnet sind. Diese befinden sich auf einer Leiterplatte 6, die zwischen dem Deckel 2 und einem Boden 1 in der Trennebene zwischen Deckel und Boden eingespannt ist. Dabei ragt die Leiterplatte bis in den Bereich des Flanschs 23 des Deckels und eines entsprechend gleich großen Flansches 24 des Bodens, wie das den Figuren 2 und 4 entnehmbar ist. Einer der Flansche 23 oder 24 kann dabei einen außen umlaufenden Vorsprung 26 aufweisen, der die Leiterplatte umfangsseitig umfaßt und in einer Vorzugslage hält. Zwischen diesem umlaufenden Vorsprung und dem Flansch des anderen Gehäuseteils ist eine Dichtung 27 eingesetzt, die z.B. ein Rundschnurring sein kann, der in entsprechende Führungsausnehmungen 28 in den Flanschen eingelegt ist. Die Verbindung der Gehäuseteile erfolgt nach Auflegen der Leiterplatte 6 auf die Flanschstirnseite 29 des Flanschs 24 und Einlegen der Dichtung 27 durch Aufsetzen des Deckels mit seiner Flanschstirnseite 30 und anschließendem Verklammern oder Verschrauben üblicher Art.

Die Leiterplatte ist nun derart ausgestaltet, daß sie die üblichen, hier nicht weiter dargestellten Leiterbahnen zur elektrischen Verbindung der einzelnen Bauelemente aufweist und daß sie zusätzlich eine vorzugsweise beidseitig aufgebrachte Kaschierung 10 aufweist, die sich im Bereich des Randes der Leiterplatte befindet, sich insbesondere bis zu ihrem äußersten Rand hin erstreckt derart, daß bei zusammengebauten Gehäusehälften die Stirnseiten 30 und 29 von Deckel und Boden in elektrisch leitenden und wärmeleitenden Kontakt mit der Kaschierung 10 kommen. Dabei weist die Kaschierung entweder dieselbe Schichthöhe wie die der Leiterbahnen auf oder es kann die Kaschierung 10, wie Figur 7 zu entnehmen, in eine Ausnehmung 43 in der Leiterplatte 6 eingebracht werden, derart, daß sie trotz einer von der Dicke üblicher Leiterbahnen abweichenden größeren Dicke bündig mit der Leiterplattenoberfläche abschließt. So ist vorteilhaft auch die Möglichkeit gegeben, sogenannte SMD-(Surface mounted devices)-Bausteine auf der Leiterplatte anzubringen. Dabei kann vorteilhaft die Kaschierung aus Kupfer bestehen und auflaminiert, aufgewalzt oder aufgalvanisiert sein. Die Wärmeleitungseigenschaften werden durch die größere Dicke der Kaschierung verbessert. Durch den Zusammenbau der beiden Gehäusehälften, Deckel und Boden, ist somit das Gehäuse in bezug auf die Trennfuge zwischen diesen Teilen elektrisch dicht und vor Störstrahlungsdurchtritt gesichert. Zusätzlich kann hiermit eine wärmeleitende Verbindung vom Innern des Gehäuses zur Gehäusewand erfolgen.

Mit der genannten Kaschierung 10 sind nun Kühlfahnen 14 der Leistungsbauelemente in wärmeleitendem Kontakt. Diese serienmäßig vorhandenen Kühlfahnen werden entweder durch Aufschrauben oder durch Auflöten oder auf andere Art in einem sicheren wärmeleitenden Kontakt mit der Kaschierung gehalten. Dazu erstreckt sich die Kaschierung so weit ins Innere des Gehäuses, daß ein sicherer Wärmeübergang mit den Bauelementen gewährleistet ist. Insbesondere erstreckt sich die Kaschierung aber auch im Bereich der vorstehenden Stege 17, die mit ihrer einander gegenüberliegenden Stirnseiten zwischen sich die Leiterplatte mit Kaschierung einspannen. Die Kaschierung der Leiterplatte ist zur Erreichung einer besseren Leitfähigkeit und insbesondere zur elektrischen Verbindung beider Gehäuseteile beidseitig vorgesehen und miteinander elektrisch und auch wärmeleitend verbunden. Dazu sind Verbindungsteile 12 vorgesehen, die durch Bohrungen in der Leiterplatte 6 hindurchgeführt sind und mit der Kaschierung jeweils verbunden sind. Hierbei können die Verbindungsteile 12 bereits in einem Arbeitsgang mit der Kaschierung bei vorgebohrter Leiterplatte erstellt werden, oder es werden Bohrungen angefertigt und diese Bohrungen elektrisch leitend ausgegossen. Auch eine stirnseitige Verbindung zwischen den beiden Kaschierungsteilen ist möglich, was die Anordnung besonders strahlungsdicht macht.

Ein drittes Ausführungsbeispiel der Erfindung gemäß Figur 8 zeigt eine Ausführungsform, bei der eine stirnseitige Abschirmung der Leiterplatte ermöglicht ist. Hierbei ist der in den Figuren 1 bis 6 gezeigte Deckel 2 zweiteilig ausgeführt, bestehend aus einem umlaufenden Rahmen 44 und einem am Rande zum Rahmen 44 hin umgebördelten Abdeckteil 45 aus Blech. Auch der Rahmen 44 ist aus Blech geformt, wie auch der Boden 46, der dem Boden 1 in den Figuren 1 bis 6 entspricht. Dieser Boden weist eine Bodenwanne 47 auf, die durch einen Flansch 48 umfangsseitig begrenzt ist, zwischen dem und dem Rahmen 44 die Leiterplatte 6 eingespannt ist. Ferner besitzt der Flansch 48 einen hochgezogenen Rand 50, der umfangsseitig die Stirnseite der Leiterplatte 6 umfaßt und weiterhin auch noch einen Teil des Rahmens 44 überlappt. Mit diesem Rand ergibt sich eine verbesserte Sicherheit gegen Störab- oder -einstrahlung.

Der aus Blech geformte Rahmen 44 weist auf der Seite der Leiterplatte 6 einen senkrecht von der Umfangswand nach innen abstehenden Flanschbereich 52 auf, der mit seiner zur Leiterplatte weisenden Oberfläche 53 die Stirnseite des Rahmens bildet, mit der der Rahmen zur Anlage an die Leiterplatte 6 kommt. Dabei erstreckt sich die Kaschierung über den gesamten Flanschbereich. Die Figur 8 zeigt einen Schnitt entlang der Linie VIII-VIII in Figur 1 und man erkennt daraus, daß dieser Schnitt durch einen der Stege 17 gezogen ist. Der Flanschbereich 52 weist also ebenfalls diese Stege 17 auf, die jedoch nicht ganz so hoch ausgeführt sind wie beim Ausführungsbeispiel nach den Figuren 1 bis 6. Die Stege 17 umschließen dann wie im vorhergehenden Ausführungsbeispiel die elektrischen Bausteine, die insbesondere Leistungsbausteine mit höherer Wärmeentwicklung sind und bilden Nischen 18 wie auch bei Figur 1 gezeigt. Damit ist auch hier eine gute Wärmeabfuhr zur Gehäuseoberfläche gewährleistet. Der Rahmen 44 kann dabei vorteilhaft als Blechbiegeteil ausgeführt werden. Aber auch ein Gußteil ist möglich.

Eine weitere Ausführungsvariante des Gehäuses zeigt Figur 9 mit wiederum einem zweiteiligen Gehäuse, einem Deckel 102 und einem Boden 101. Beide Teile sind aus Blech geformt, wobei der Boden wiederum als Bodenwanne 147 ausgeführt ist, wie beim Ausführungsbeispiel nach Figur 8, und einen umlaufenden, ggf. durch Anschlüsse unterbrochenen Außenflansch 148 aufweist. Der Deckel 102 ist ähnlich wie bei Figur 8 mit einem Flanschbereich 152 versehen, wobei hier von dem Rand des topfförmigen Deckels 102 Teile flanschartig nach innen gebogen sind unter Bildung eines Flanschbereiches 152, wie bei Figur 8, und wobei andere Teile des Randes flanschartig nach außen gebogen sind unter Bildung eines Außenflansches 54, zwischen dem und dem umlaufenden Außenflansch 148 des Bodens 104 die Leiterplatte fest eingespannt ist. Die Kaschierung erstreckt sich dann sowohl auf den Außenflansch 50 als auch den Flanschbereich 152 und natürlich auch auf den außen umlaufenden Flansch 148 des Bodens 101. Der Flanschbereich 152 bildet wiederum analog zur Ausgestaltung nach Figur 8 Nischen, in die elektrische Bauelemente 3 gesetzt sind.

Durch die Anordnung der Leistungsbausteine in Nischen 18 und ihre wärmeleitende Verbindung mit der Kaschierung 10 wird die in den Leistungsbausteinen entstehende Wärme unmittelbar sofort an das Gehäuse weitergeleitet, von wo aus die Wärme nach außen abstrahlen kann. Durch die Unterbringung der Leistungsbauelemente 3 in den Nischen 18 wird ferner Strahlungs- und Konvektionswärme an die benachbarten Gehäusewandteile besser abgegeben, als es in anderer Anordnung der Bauelemente auf der Leiterplatte möglich wäre. Auf diese Weise werden die Leistungsbauelemente in optimaler Weise gekühlt.

Da in einer Schaltung eines Steuergerätes außer Leistungsbauelementen noch andere Steuerelemente 4 vorhanden sind, die gegen elektromagnetische Störeinstrahlung geschützt werden müssen oder die selbst elektromagnetisch abstrahlen und andere Bauteile stören würden, ist das erfindungsgemäße Gehäuse weiterhin so ausgestaltet, daß von der an die Umfangswand angrenzenden Gehäusewand 34 ein oder mehrere Stutzen 19 senkrecht nach innen vorstehen, die ferner senkrecht auf die Trennebene 33 der Gehäuseteile zulaufen und bündig mit der Stirnseite 30 enden. Diesen Stutzen am einen Gehäuseteil liegen entsprechende von der Wand 35 des anderen Gehäuseteils vorstehende Stutzen fluchtend gegenüber. Die Stirnseiten dieser Stutzen 19 spannen zwischen sich die Leiterplatte 6 ein, wie das in Figur 2 ersichtlich ist. Im Bereich der Stirnseite der Stutzen ist die Leiterplatte wiederum mit einer durchkontaktierten Kaschierung 21 versehen, so daß die Stutzen an dieser Stelle elektrisch leitend miteinander in Verbindung stehen. Die Stutzen schließen somit zwischen sich bzw. zwischen sich und der Leiterplatte einen Bereich 37 ein, der störstrahlungsdicht ist und darin befindliche Steuerelemente 4 gegen Störeinstrahlung schützen bzw. außenliegende Elemente vor Störabstrahlung von den Bausteinen innerhalb des Bereiches 37 schützen. Die Kaschierung ist vorteilhaft aus Kupfer, das sowohl gute elektrisch leitende als auch gute wärmeleitende Eigenschaften aufweist. Die Durchkontaktierung der Kontaktierung 21 zwischen den Stutzen kann auch dadurch erfolgen, daß von der Stirnseite der Stutzen auf der einen Seite kleine Zapfen 39 abstehen, wie das der Figur 6 entnehmbar ist, die durch eine entsprechende Bohrung durch Leiterplatte und Kontaktierung im zusammengebauten Zustand der Gehäuseteile hindurchgreifen und in eine entsprechende Bohrung in der Stirnseite des Stutzens der anderen Seite elektrisch kontaktierend eingreifen. In der Figur 6 ist zur besseren Darstellung ein Schnitt durch die zusammengebauten Gehäuseteile gelegt ohne eingesetzte Leiterplatte. Die Figur 5 zeigt ein Bild der der anderen Gehäusehälfte zugewandten Stirnseite 29 des Bodens 1 des Gehäuses. Hier sind im Bereich des Stutzens 19 die Bohrungen 40 erkennbar, in die die Zapfen 39 eingreifen.

In den Figuren 10 und 11 ist ein Gehäuse dargestellt, bei dem die Leiterplatte 6 wie bei den Ausführungsbeispielen zuvor zwischen Boden 1 und Deckel 2 eingespannt ist. Auf der Oberseite der Leiterplatte 6 sind, wie bei den Ausführungsbeispielen zuvor, Leistungsbauelemente 3 und Steuerelemente 4 angeordnet. Darüberhinaus ist die Leiterplatte in ihrem Randbereich beidseitig mit der Kaschierung 10 versehen. Abweichend von den zuvor beschriebenen Ausführungsbeispielen ist die Kaschierung 10 in diesem Ausführungsbeispiel so ausgeführt, daß einzelne Leistungsbauelemente 3 oder gruppenweise zusammengefaßte Leistungsbauelemente parzellenartig umschlossen sind. Es ist selbstverständlich, daß dabei im Bereich von Leiterbahnen auf der Leiterplatte 6 keine Kaschierung 10 aufgebracht ist. Die Kaschierung ist in diesen Bereichen bis an die Leiterbahnen herangeführt, ohne diese zu berühren. Im Boden 1 und Deckel 2 sind Stege 171 ausgebildet, die etwa senkrecht zur Leiterplattenoberfläche verlaufen und mit den Umfangswänden 16 bzw. der Oberseite des Deckels 2 oder der Unterseite des Bodens 1 verbunden sind. Diese Stege 171 sind so ausgebildet, daß sie die auf der Leiterplatte 6 ausgebildeten Parzellen 181 umfassen bzw. begrenzen. Dazu liegen die Stirnseiten der Stege 171 auf der Leiterplatte 6 bzw. auf der Kaschierung 10 auf. Im Bereich von Leiterbahnen auf der Leiterplatte 6, die bei der Bestückung mit SMD-Bauelementen auf der Oberseite Unterseite der Leiterplatte ausgebildet sind, aber auch auf beiden Seiten der Leiterplatte verlaufen können, zum Beispiel bei der beidseitigen Bestückung mit Bauelementen oder bei der Bestückung mit SMD-Bauelementen und Bauelementen in Drahtbauweise auf einer Leiterplattenseite, sind Ausnehmungen 172 in den Stegen 171 ausgebildet, die die Leiterbahnen mit Abstand umgreifen. Die Stege 171 sind im Boden 1 und Deckel 2 jeweils so ausgebildet, daß sie miteinander fluchten und jeweils auf der Ober- bzw. Unterseite der Leiterplatte 6 auf der entsprechenden Kaschierung 10 aufliegen. Die Stege 171 sind im wesentlichen so orientiert, daß sie parallel zu einer der Umfangswände 16 verlaufen. Sie können jedoch auch jede andere Orientierung einnehmen. Durch diesen parzellenartigen Aufbau der Leiterplatte und durch die entsprechend ausgebildeten Stege 171, die auf der Leiterplatte 6 aufliegen, wird die Schwingstabilität des Gehäuses wesentlich verbessert. Darüberhinaus sind einzelne Leistungsbauelemente 3 bzw. Gruppen von Leistungsbauelementen 3 und/oder Steuerelementen 4 in nahezu geschlossenen Kammern untergebracht, wodurch einerseits die Wärmeabfuhr verbessert wird und andererseits die Konvektion und damit der Einfluß auf andere Bauelemente örtlich begrenzt bzw. verhindert wird.

Vorstehendend wurde ein zweiteiliges bzw. im wesentlichen zweiteiliges Gehäuse gezeigt. Dabei ist es selbstverständlich, daß ein solches Gehäuse auch dreiteilig oder mehrteilig ausgeführt werden kann mit einem zwischen Deckel und Boden liegenden Zwischenteil, insbesondere dann wenn z.B. zwei Leiterplatten in der genannten Art und Weise mit dem Gehäuse verbunden werden sollen.

Figur 3 zeigt die Ansicht von der Seite, von der die Schaltung kontaktiert wird. Hier ist ein dreiteiliger Steckanschluß 41 zu sehen, der mit Ausnehmungen 42 am Rand kodiert ist.

Mit dem erfindungsgemäßen Gehäuse läßt sich in sehr einfacher Weise eine störstrahldichte Abschirmung von empfindlichen elektrischen Bauelementen erzielen und in einfacher Weise auch eine gute Kühlung der Leistungsbauelemente erreichen, ohne daß zusätzliche Kühlelemente notwendig wären.

## Patentansprüche

1. Gehäuse für Steuergeräte mit mehreren, miteinander fest verbindbaren Gehäuseteilen (1, 2) bestehend aus wenigstens einem Bodenteil (1) und einem Deckelteil (2) aus elektrisch leitendem und wärmeleitendem Material mit wenigstens einem innerhalb des Gehäuses angeordneten, elektrische Leistungsbauelemente (3) und Steuerbauelemente (4) einer Schaltung tragenden Trägerelement (6), welche Bauelemente über Leitungen und/oder Leitungsbahnen auf dem Trägerelement und insbesondere über wenigstens ein in dem Gehäuse festgelegtes Steckerelement von außen elektrisch anschließbar sind, dadurch gekennzeichnet, daß das Trägerelement eine Leiterplatte (6) ist, die mit wenigstens einem Teil ihres Außenumfangs zwischen Teilen der Gehäuseteile (1, 2), insbesondere des Bodenteiles (1) und des Deckelteiles (2) eingespannt ist und an der Einspannstelle und einem daran angrenzenden Bereich eine in elektrisch leitenden und wärmeleitenden Kontakt mit wenigstens einen der Gehäuseteile angebrachte Kaschierung (10) aus elektrisch leitendem und wärmeleitendem Material aufweist und die Leistungsbauelemente (3) mit der Kaschierung (10) wärmeleitend verbunden sind.

2. Gehäuse nach Anspruch 1, dadurch gekennzeichnet, daß die Kaschierung (10) beidseitig auf der Leiterplatte (6) aufgebracht ist und die Kaschierungen auf den beiden Seiten der Leiterplatte durch leitende, durch die Leiterplatte hindurch geführte Verbindungsteile (12) miteinander verbunden sind.

3. Gehäuse nach Anspruch 1 oder 2, dadurch gekennzeichnet, daß die Kaschierung (10) in einer Ausnehmung (43) der Leiterplatte (6) angeordnet ist mit insbesondere einer Tiefe die der Höhe der Kaschierung entspricht.

4. Gehäuse nach Anspruch 3, dadurch gekennzeichnet, daß die Kaschierung (10) als Kupferschicht innerhalb der Ausnehmung (43) aufgewalzt wird.

5. Gehäuse nach Anspruch 2 bis 4, dadurch gekennzeichnet, daß die Verbindungsteile (12) durch Bohrungen in der Leiterplatte geführt sind.

6. Gehäuse nach Anspruch 5, dadurch gekennzeichnet, daß die Kaschierung die Bohrungen einschließt und durch diese von der einen Kaschierung (10) zur anderen hindurchgreift.

7. Gehäuse nach einem der Ansprüche 1 bis 6, dadurch gekennzeichnet, daß die Kaschierung (10) aus Kupfer besteht.

8. Gehäuse nach einem der vorstehenden Ansprüche 1 bis 7, dadurch gekennzeichnet, daß die Kaschierung (10) umlaufend die Ränder der Leiterplatte abdeckt.

9. Gehäuse nach einem der Ansprüche 1 bis 8, dadurch gekennzeichnet, daß die Leistungsbauelemente (3) Kühlfahnen (14) haben, über die sie mit der Leiterplatte verbunden sind, insbesondere verlötet sind.

10. Gehäuse nach einem der Ansprüche 1 bis 9, dadurch gekennzeichnet, daß die Gehäuseteile (1, 2) von ihrer zur Trennebene zwischen den Gehäuseteilen senkrecht stehenden Umfangswand (16) vorstehende Stege (17, 171) aufweisen, die fluchtend sich in dem jeweils gegenüberliegenden Gehäuseteil fortsetzen und in der Ebene der Stirnseite der Gehäuseteile enden und dort zwischen sich die Leiterplatte (6) bei fest miteinander verbundenen Gehäuseteilen (1, 2) einspannen, wobei sich die Kaschierung (10) zumindest über einen Teil der Stirnseite der Stege erstreckt.

11. Gehäuse nach einem der Ansprüche 1 bis 10, dadurch gekennzeichnet, daß die Gehäuseteile (1, 2) von ihrer zur Trennebene zwischen den Gehäuseteilen parallel verlaufenden Außenwand vorstehende Stege (171) aufweisen, die fluchtend sich in dem jeweils gegenüberliegenden Gehäuseteil fortsetzen und in der Ebene der Stirnseite der Gehäuseteile enden und dort zwischen sich die Leiterplatte (6) bei fest miteinander verbundenen Gehäuseteilen (1, 2) einspannen, wobei sich die Kaschierung (10) zumindest über einen Teil der Stirnseite der Stege (171) erstreckt.

12. Gehäuse nach einem der Ansprüche 1 bis 11, dadurch gekennzeichnet, daß wenigstens eines der Gehäuseteile (44) von seiner zur Trennebene (33) senkrecht stehenden Umfangswand einen wenigstens zum Teil umlaufenden, nach innen ragenden Flanschbereich (52) aufweist, der als Stirnseite des Gehäuseteils an der Leiterplatte (6) und ihrer Kaschierung (10) zur Anlage kommt und Stege (17, 171) bildet, die elektrische Bauelemente (3), insbesondere Leistungsbauelemente auf der Leiterplatte nischenbildend umfassen.

13. Gehäuse nach einem der Ansprüche 10 bis 12, dadurch gekennzeichnet, daß die Stege (17, 171) parzellenartige Felder (181) auf der Leiterplatte (6) begrenzen.

14. Gehäuse nach Anspruch 12, dadurch gekennzeichnet, daß der Flanschbereich aus nach innen umgebogenen Teilstücken der Gehäusewand besteht und daß andere, nach außen umgebogene Teilstücke der Gehäusewand einen Außenflanschbereich (54) des Gehäuseteils bilden, zwischen welchem und dem anderen Gehäuseteil (148, 147) die Leiterplatte (6) mit ihrer Kaschierung (10) eingespannt ist.

15. Gehäuse nach einem der Ansprüche 10 bis 14, dadurch gekennzeichnet, daß die Stege (17, 171) in ihren an der Leiterplatte (6) anliegenden Stirnseiten Ausnehmungen (172) zur Durchführung von Leiterbahnen aufweisen.

16. Gehäuse nach einem der Ansprüche 10 bis 12 und 14, 15, dadurch gekennzeichnet, daß die Leistungsbauelemente von den Stegen (17, 171) und der Umfangswand (16) nischenbildend umschlossen sind.

17. Gehäuse nach einem der vorstehenden Ansprüche, dadurch gekennzeichnet, daß von der Gehäusewand (34) des einen der Gehäuseteile wenigstens ein Stutzen (19) absteht, der mit einem von der gegenüberliegenden Gehäusewand (35) des angrenzenden Gehäuseteils abstehenden Stutzen (19) fluchtet und daß zwischen den Stirnseiten (20) der Stutzen die Leiterplatte eingespannt ist.

18. Gehäuse nach Anspruch 17, dadurch gekennzeichnet, daß die Leiterplatte (6) an der Einspannstelle zwischen den Stutzen (19) beidseitig mit einer durchkontaktierten Kaschierung (21) wenigstens elektrisch leitender Art versehen ist.

19. Gehäuse nach Anspruch 18, dadurch gekennzeichnet, daß die durchkontaktierte Kaschierung (21) an der Einspannstelle mit der Kaschierung (10) am Außenumfang der Leiterplatte elektrisch leitend verbunden ist.

20. Gehäuse nach Anspruch 19, dadurch gekennzeichnet, daß die durchkontaktierte Kaschierung (21) mit der Kaschierung (10) am Außenumfang der Leiterplatte thermisch leitend verbunden ist.

21. Gehäuse nach einem der vorstehenden Ansprüche, dadurch gekennzeichnet, daß das Gehäuse mit einem Erdungsanschluß verbunden ist.

22. Gehäuse nach einem der Ansprüche 17 bis 21, dadurch gekennzeichnet, daß innerhalb des von den Stutzen (19) umschlossenen Bereichs (37) die elektrischen Bauelemente (4) angeordnet sind, die gegen eine elektrische bzw. elektromagnetische Einstrahlung oder eine elektrische bzw. elektromagnetische Abstrahlung nach außen geschützt werden müssen.

23. Gehäuse nach einem der vorstehenden Ansprüche, dadurch gekennzeichnet, daß die Gehäuseteile (1, 2) einen Flansch (23) aufweisen, und im Bereich des Flansches miteinander fest verbunden, verklammert oder verschraubt sind.

24. Gehäuse nach einem der Ansprüche 1 bis 22, dadurch gekennzeichnet, daß wenigstens eines der Gehäuseteile einen Flansch (48) aufweist, der einen in Richtung zum anderen Gehäuseteil hochgezogenen Rand (50) hat, der die Leiterplatte (6) stirnseitig und das andere Gehäuseteil überlappend umfaßt.

## Claims

1. Housing for control devices, having a plurality of housing parts (1, 2) that can be firmly connected to one another, comprising at least one bottom part (1) and one cover (2) made of electrically conducting and heat-conducting material, having at least one carrier element (6) that is arranged inside the housing and bears electrical power components (3) and control components (4) of a circuit, which components can be electrically connected from the outside via lines and/or conductive tracks on the carrier element and in particular via at least one plug element fastened in the housing, characterized in that the carrier element is a printed circuit board (6) which is clamped with at least one part of its outer circumference between parts of the housing parts (1, 2), in particular of the bottom part (1) and of the cover part (2), and, at the clamping point and an area adjacent thereto, has a lamination (10) that is applied in electrically conducting and heat-conducting contact with at least one of the housing parts and consists of electrically conducting and heat-conducting material, and the power components (3) are connected to the lamination (10) in a heat-conducting manner.

2. Housing according to Claim 1, characterized in that the lamination (10) is applied on both sides to the printed circuit board (6), and the laminations on both sides of the printed circuit board are connected to each other by conducting connecting parts (12) led through the printed circuit board.

3. Housing according to Claim 1 or 2, characterized in that the lamination (10) is arranged in a cut-out (43) of the printed circuit board (6), in particular with a depth which corresponds to the height of the lamination.

4. Housing according to Claim 3, characterized in that the lamination (10) is rolled on as a copper layer inside the cut-out (43).

5. Housing according to Claims 2 to 4, characterized in that the connecting parts (12) are led through holes in the printed circuit board.

6. Housing according to Claim 5, characterized in that the lamination includes the holes and reaches from one lamination (10) to the other through said holes.

7. Housing according to one of Claims 1 to 6, characterized in that the lamination (10) consists of copper.

8. Housing according to one of the preceding Claims 1 to 7, characterized in that the lamination (10) covers the edges of the printed circuit board circumferentially.

9. Housing according to one of Claims 1 to 8, characterized in that the power components (3) have cooling tabs (14) via which they are connected, in particular soldered, to the printed circuit board.

10. Housing according to one of Claims 1 to 9, characterized in that the housing parts (1, 2) have webs (17, 171) projecting from their circumferential wall (16) which is perpendicular to the separation plane between the housing parts, said webs continuing flush into the respectively opposite housing part and ending in the plane of the front side of the housing parts and clamping the printed circuit board (6) there between themselves when the housing parts (1, 2) are firmly connected to each other, the lamination (10) extending at least over part of the front side of the webs.

11. Housing according to one of Claims 1 to 10, characterized in that the housing parts (1, 2) have webs (171) projecting from their outer wall running parallel to the separation plane between the housing parts, said webs continuing flush into the respectively opposite housing part and ending in the plane of the front side of the housing parts and clamping the printed circuit board (6) there between themselves when the housing parts (1, 2) are firmly connected to each other, the lamination (10) extending at least over part of the front side of the webs (171).

12. Housing according to one of Claims 1 to 11, characterized in that at least one of the housing parts (44) has a flange region (52) which projects inwards from its circumferential wall, which is at right angles to the separation plane (33), and runs at least partially circumferentially, said flange region (52) coming to rest as the front side of the housing part on the printed circuit board (6) and its lamination (10) and forming webs (17, 171) which enclose electrical components (3), in particular power components, on the printed circuit board to form niches.

13. Housing according to one of Claims 10 to 12, characterized in that the webs (17, 171) bound plot-like fields (181) on the printed circuit board (6).

14. Housing according to Claim 12, characterized in that the flange region consists of parts of the housing wall which are bent inwards and in that other parts of the housing wall, which are bent outwards, form an outer flange region (54) of the housing part, between which and the other housing part (148, 147) the printed circuit board (6) with its lamination (10) is clamped.

15. Housing according to one of Claims 10 to 14, characterized in that the webs (17, 171) have, in their front sides resting on the printed circuit board (6), cut-outs (172) for leading through conductor tracks.

16. Housing according to one of Claims 10 to 12 and 14, 15, characterized in that the power components are enclosed by the webs (17, 171) and the circumferential wall (16) to form niches.

17. Housing according to one of the preceding claims, characterized in that there sticks out from the housing wall (34) of one of the housing parts at least one stub (19) which is flush with a stub (19) sticking out from the opposite housing wall (35) of the adjacent housing part, and in that the printed circuit board is clamped between the front sides (20) of the stubs.

18. Housing according to Claim 17, characterized in that the printed circuit board (6) is provided, at the clamping point between the stubs (19), on both sides with a through-plated lamination (21) of at least an electrically conducting type.

19. Housing according to Claim 18, characterized in that the through-plated lamination (21) is connected in an electrically conducting manner at the clamping point to the lamination (10) at the outer circumference of the printed circuit board.

20. Housing according to Claim 19, characterized in that the through-plated lamination (21) is connected in a thermally conducting manner to the lamination (10) at the outer circumference of the printed circuit board.

21. Housing according to one of the preceding claims, characterized in that the housing is connected to an earthing connection.

22. Housing according to one of Claims 17 to 21, characterized in that there are arranged, inside the region (37) enclosed by the stubs (19), those electrical components (4) which must be protected from electrical or electromagnetic immission or must be protected against electrical or electromagnetic emission to the outside.

23. Housing according to one of the preceding claims, characterized in that the housing parts (1, 2) have a flange (23) and, in the region of the flange, are firmly connected, clamped or screwed to each other.

24. Housing according to one of Claims 1 to 22, characterized in that at least one of the housing parts has a flange (48) which has an edge (50) which is drawn up in the direction of the other housing part and which encloses the printed circuit board (6) at the front side and encloses the other housing part with an overlap.

## Revendications

1. Boîtier pour recevoir des appareils de commande comportant plusieurs parties de boîtier (1, 2) reliées solidairement, avec au moins une partie de fond (1) et une partie de couvercle (2) en une matière conductrice électrique et thermique, avec au moins un élément de support (6) muni d'un circuit logé dans le boîtier et garni de composants de puissance (3), électriques et de composants de commande (4), ces composants étant raccordés par des lignes et/ou des chemins conducteurs portés par l'élément de support et notamment par au moins un élément de connecteur fixé au boîtier, pour un branchement électrique à partir de l'extérieur, caractérisé en ce que l'élément de support est une plaque de circuit imprimé (6) fixée au moins sur une partie de sa périphérie entre les parties de boîtier (1, 2) notamment la partie de fond (1) et la partie de couvercle (2), et le point de serrage et la zone adjacente comportent un doublage (10) en contact électrique et thermique avec au moins l'une des parties de boîtier, ce doublage étant en un matériau conducteur électrique et thermique, les composants de puissance (3) étant reliés au doublage (10) d'une manière conductrice de la chaleur.

2. Boîtier selon la revendication 1, caractérisé en ce que le doublage (10) est appliqué sur les deux faces de la plaque de circuit imprimé (6) et les revêtements des deux faces de la plaque sont reliés par des pièces de liaison (12) traversant la plaque de circuit imprimé.

3. Boîtier selon la revendication 1 ou 2, caractérisé en ce que le doublage (10) est prévu dans une cavité (43) de la plaque de circuit imprimé (6) avec notamment une profondeur qui correspond à l'épaisseur du revêtement.

4. Boîtier selon la revendication 3, caractérisé en ce que le doublage (10) est laminé sous la forme d'une couche de cuivre à l'intérieur de la cavité (43).

5. Boîtier selon les revendications 2 à 4, caractérisé en ce que les pièces de liaison (12) traversent des perçages de la plaque de circuit imprimé.

6. Boîtier selon la revendication 5, caractérisé en ce que le revêtement englobe les perçages à travers lesquels on passe un doublage (10) à l'autre.

7. Boîtier selon l'une des revendications 1 à 6, caractérisé en ce que le doublage (10) est en cuivre.

8. Boîtier selon l'une des revendications précédentes 1 à 7, caractérisé en ce que le doublage (10) recouvre de manière périphérique les bords de la plaque de circuit imprimé.

9. Boîtier selon l'une des revendications 1 à 8, caractérisé en ce que les composants de puissance (3) ont des ailettes de refroidissement (14) reliées à la plaque de circuit imprimé, notamment par soudure.

10. Boîtier selon l'une des revendications 1 à 9, caractérisé en ce que les parties de boîtier (1, 2) comportent des entretoises (17, 171) en saillie à partir de leur plan de jonction entre les parties de boîtier, perpendiculairement à la paroi périphérique (16), ces entretoises se poursuivant de manière alignée dans la partie de boîtier chaque fois opposée et se terminant dans le plan de la face frontale de la partie de boîtier, pour y enserrer la plaque de circuit imprimé (6) lorsque les parties de boîtier (1, 2) sont reliées l'une à l'autre, le doublage (10) s'étendant sur au moins une partie de la face frontale des entretoises.

11. Boîtier selon l'une des revendications 1 à 10, caractérisé en ce que les parties de boîtier (1, 2) ont des entretoises (171) partant du plan de jonction des parties de boîtier, en étant parallèles à la paroi extérieure, ces entretoises se prolongeant de manière alignée dans la partie de boîtier opposée, et se terminent dans la plan de la face frontale de la partie de boîtier, pour y enserrer la plaque de circuit imprimé (6) lorsque les parties de boîtier (1, 2) sont reliées l'une à l'autre, le doublage (10) s'étendant sur au moins une partie de la face frontale des entretoises (171).

12. Boîtier selon l'une des revendications 1 à 11, caractérisé en ce qu'au moins l'une des parties de boîtier (44) comporte une zone de brides (52) en saillie vers l'intérieur, partant de sa paroi périphérique perpendiculaire au plan de jonction (33), et cette zone de brides est au moins en partie périphérique, et vient en appui comme face frontale de la partie de boîtier contre la plaque de circuit imprimé (6) et son doublage (10) et constitue des entretoises (17, 171) pour entourer les composants électriques (3), notamment les composants de puissance, portés par la plaque de circuit imprimé, en formant des niches.

13. Boîtier selon l'une des revendications 10 à 12, caractérisé en ce que les entretoises (17, 171) délimitent des champs (181) en forme de parcelles sur la plaque de circuit imprimé (6).

14. Boîtier selon la revendication 12, caractérisé en ce que la zone de brides se compose de parties de paroi de boîtier recourbées vers l'intérieur et en ce que d'autres parties de la paroi de boîtier recourbées vers l'extérieur forment une zone de brides extérieures (54) de la partie de boîtier et entre celle-ci et l'autre partie de boîtier (148, 147) se trouve enserrée la plaque de circuit imprimé (6) et son doublage (10).

15. Boîtier selon l'une des revendications 10 à 14, caractérisé en ce que les entretoises (17, 171) comportent sur leur face frontale appliquée contre la plaque de circuit imprimé (6), des cavités (172) pour laisser passer les chemins conducteurs.

16. Boîtier selon l'une des revendications 10 à 12 et 14, 15, caractérisé en ce que les composants de puissance sont entourés par les entretoises (17, 171) et la paroi périphérique (16) en formant des niches.

17. Boîtier selon l'une des revendications précédentes, caractérisé en ce qu'au moins une entretoise (19) est en saillie de la paroi de boîtier (34) de l'une des parties de boîtier, cette entretoise étant alignée avec un appui (19) en saillie de la paroi opposée (35) de la partie de boîtier adjacente et la plaque de circuit imprimé est enserrée entre les faces frontales (20) des entretoises.

18. Boîtier selon la revendication 17, caractérisé en ce que la plaque de circuit imprimé (6) est munie, au point de serrage entre les appuis (19), des deux côtés, d'un doublage (21) assurant le contact traversant au moins pour la conduction électrique.

19. Boîtier selon la revendication 18, caractérisé en ce que le doublage de mise en contact traversant (21) au point de serrage du doublage (10) est relié en conduction électrique avec la périphérie de la plaque de circuit imprimé.

20. Boîtier selon la revendication 19, caractérisé en ce que le doublage de contact traversant (21) est relié en conduction thermique avec le doublage (10) à la périphérie de la plaque de circuit imprimé.

21. Boîtier selon l'une des revendications précédentes, caractérisé en ce qu'il est relié à une borne de masse.

22. Boîtier selon l'une des revendications 17 à 21, caractérisé en ce que dans la zone (37), entourée par les appuis (19), se trouvent les composants électriques (4) qui sont à protéger contre la réception d'ondes électriques ou électromagnétiques ou qui doivent être protégés contre l'émission vers l'extérieur d'ondes électriques ou électromagnétiques.

23. Boîtier selon l'une des revendications précédentes, caractérisé en ce que les parties de boîtier (1, 2) comportent une bride (23) et au niveau de cette bride les parties de boîtier sont reliées solidairement par des pinces ou sont vissées.

24. Boîtier selon l'une des revendications 1 à 22, caractérisé en ce qu'au moins l'une des parties de boîtier comporte une bride (48) ayant un bord (50) relevé en direction de l'autre partie de boîtier, et qui entoure frontalement la plaque de circuit imprimé (6) et chevauche l'autre partie de boîtier.
